# EUROPEAN PATENT APPLICATION

(11) **EP 1 465 017 A2**
(43) Date of publication of application: **06.10.2004**
(21) Application number: 04007823.0
(22) Date of filing: 31.03.2004
(51) Int. Cl.: G03F 9/00

(54) **Semiconductor wafer and exposure mask with alignment marks, mark detecting method and method of exposure**

(30) Priority: 01.04.2003 JP 2003097625
(71) Applicant: SONY CORPORATION, Tokyo (JP)
(72) Inventor: Nohdo, Shinichiro, Shinagawa-ku Tokyo (JP)
(74) Representative: Müller - Hoffmann & Partner

(57) **Abstract**

A wafer, exposure mask, method for detecting an alignment mark and method for exposure, which make it possible to improve accuracy of the alignment as well as correction of a gap between the wafer and the exposure mask, are provided. There is provided a wafer having alignment marks (wafer marks) with edges for causing inspection light for alignment to scatter at an exposure surface during proximity exposure. The wafer mark is characterized by having dot pattern groups, which are made up of dot patterns arrayed in a predetermined direction. The dot pattern group is configured by arranging dot patterns in Direction X with an arrangement interval P2. The arrangement interval P2 is wider than an arrangement interval P1 for the dot patterns. Further, there is provided an exposure mask , which is used in similar proximity exposure, having alignment marks, as mask marks, which have a similar configuration as that of the wafer marks.

## Description

### CROSS REFERENCES TO RELATED APPLICATIONS

The present invention claims priority to its priority document No. 2003-097625 filed in the Japanese Patent Office on April 1, 2003, the entire contents of which being incorporated by reference herein.

### BACKGROUND OF THE INVENTION

### 1. Field of the Invention

The present invention relates to a wafer, exposure mask, method for detecting alignment mark and method for exposure, which have alignment marks to be used for proximity exposure.

### 2. Description of Related Art

Today an optical lithography is the mainstream in a lithography process in semiconductor device production. In an advanced 0.09 µm generation an exposure device used a wavelength of 193 nm ArF excimer laser light source is implemented in mass production. However, in the next 65 nm generation, LEEPL (Low energy electron beam proximity projection lithography) that enables 1X magnification proximity exposure by using 2 kV low energy electron beam is one of the prime candidates of a technology in a lithography process.

In the proximity exposure performed by disposing a wafer in proximity to an exposure mask, as in the above-mentioned LEEPL, SLA (scattered-light alignment) is adopted in an alignment of the wafer and the exposure mask.

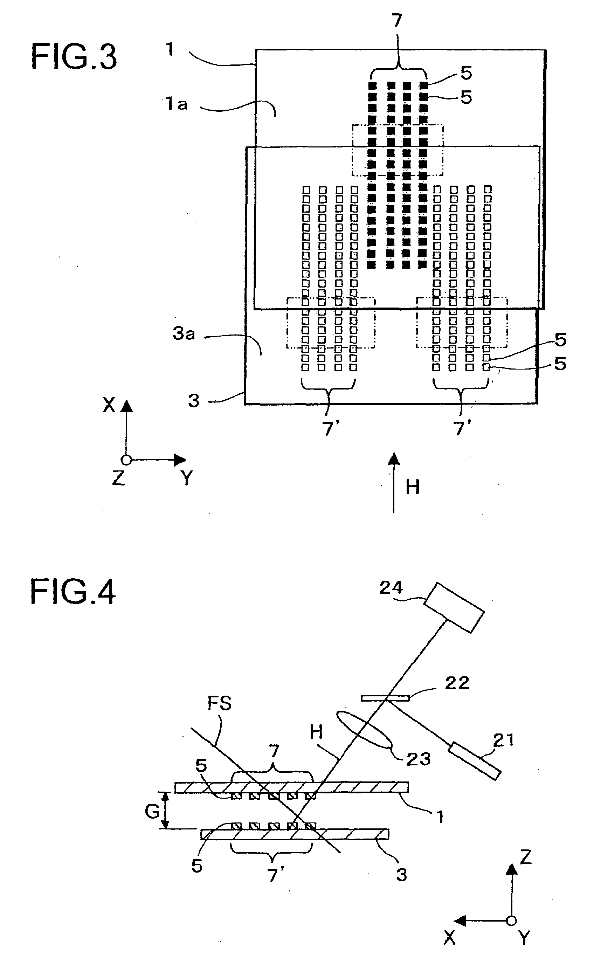

As shown in a relevant close-up view of Fig. 3, the alignment marks (a mask mark 7, a wafer mark 7'), in which dot patterns 5 are arrayed in a predetermined direction (for example, in Direction X in the figure) are respectively provided both on a surface 1a of an exposure mask 1 and on an exposure surface 3a of a wafer 3. These mask mark 7s and wafer mark 7' are arrayed both on the surface 1a of the exposure mask 1 and on the exposure surface 3a of the wafer 3 in such a way that the dot pattern 5 is arrayed in a predetermined arrangement state in which the dot pattern 5 is aligned in the same direction when the exposure mask 1 is disposed in proximity to the exposure surface 3a of the wafer 3. For example here, there is a configuration in which the mask mark 7, which is in the same arrangement state as the wafer mark 7', is arranged in halfway between two wafer mark 7' , in which the dot pattern 5 are arrayed in four rows in the Direction X. Further, these mask mark 7 and wafer mark 7' are provided at a plurality of portions of the surface 1a of the exposure mask 1 and the exposure surface 3a of the wafer 3 in respective directions.

As shown in Fig. 4, an exposure device employing the SLA method has inspection optic systems including a light source 21, a half mirror 22, a lens 23 and an image detector 24 on a plurality of portions around a mask stage (not shown in the figure). Each inspection optic system is configured such that an inspection light H emitted from the light source 21 is incident from an oblique direction onto the surface 1a of the exposure mask 1 on the mask stage. Further, through the half mirror 22 and the lens 23, the inspection light H is incident onto the exposure surface 3a of the wafer 3 through the exposure mask 1. Scattering lights generated at the edge of the wafer 3, a wafer 11 and the dot pattern 5 on the exposure mask 1 are detected by the image detector 24. The inspection optic systems configured as described above are provided in correspondence with the portions at which the mask mark 7 and the wafer mark 7' of the exposure mask 1 and the wafer 3, which are arranged in the predetermined state, are disposed respectively. Further, the inspection optic systems are configured such that a plane of incidence for the inspection light H is parallel to the above-mentioned arrangement direction of the dot pattern 5 (direction X in the figure). For example, see Japanese Patent Publication No. 2955668.

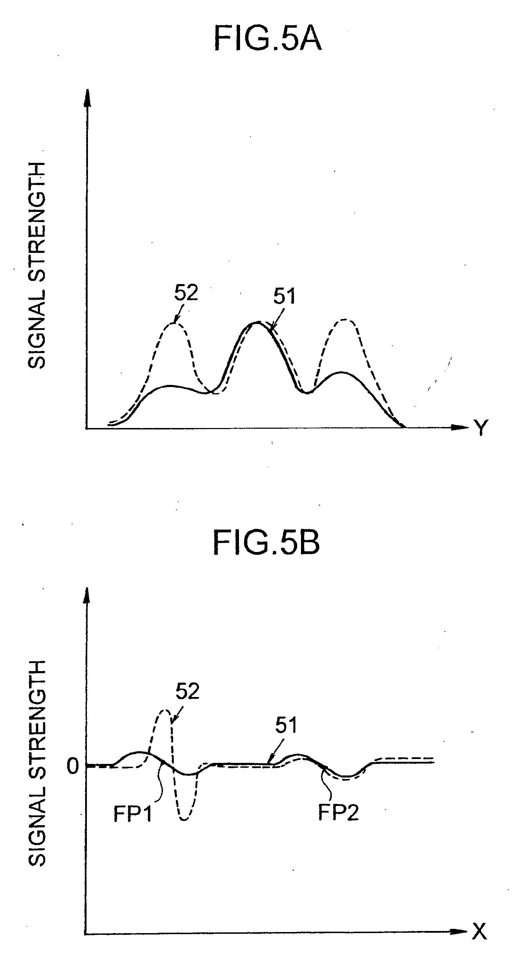

When the alignment is performed, the scattered lights of the inspection light H from the mask mark 7 and the wafer mark 7' are detected as image signal by the inspection optic systems disposed on respective portions. As described above with Fig. 3, if the exposure mask 1 and the wafer 3 are arranged in the predetermined state, the mask mark 7 is positioned in the halfway between two wafer marks 7'. Accordingly, as shown in Fig. 5A, three peaks are observed in correspondence with the arrangement positions of the mask marks 7 and the wafer mark 7' in a signal strength 51 of an image signal which is measured in the perpendicular direction to the arrangement direction of the dot pattern 5. Accordingly, a X-Y component, θ component and magnification component between the exposure mask 1 and the wafer 3 is detected from positions of these peaks.

In addition, as described above with Fig. 4, the inspection light H is incident onto the exposure mask 1 and the wafer 3 from an oblique direction so as that the plane of incidence of the inspection light H is parallel to the above-mentioned arrangement direction of the dot pattern 5. Accordingly, the focus plane FS obliquely crosses the exposure mask 1 and the wafer 3, and the focus position in the image signal is shifted in the arrangement direction of the dot pattern 5 (shown in a double-dashed line on Fig. 3) for an amount corresponding to a size of a gap G between the exposure mask 1 and the wafer 3. As shown in Fig. 5B, a focus position FP1 in the side of wafer mark 7' and a focus position FP2 in the side of mask mark 7 are detected by differentiation-processing of the signal strength in the arrangement direction of the dot pattern 5. The shift of the gap G between the exposure mask 1 and the wafer is detected from these focus positions FP1 and FP2.

### SUMMARY OF THE INVENTION

However, in above-mentioned SLA method, images of alignment marks, i.e. the mask mark and the wafer mark, of both the exposure mask side and the wafer side are simultaneously detected, and an automatic gain control is applied. Accordingly, if a difference of both signal strength is large, the accuracy of detection decreases due to an insufficient signal strength for operation. Specifically, it is desirable to increase the signal strength of the alignment mark in the wafer side up to approximately the same strength as that of the alignment mark in the exposure mask side because the signal strength of the alignment mark in the wafer side may change depending on a wafer process. Further, recently, the gap between the wafer and the exposure mask plays the more critical role in securing the accuracy of exposure. Accordingly, it is desirable to further improve the accuracy of detection of the gap between the wafer and exposure mask.

In view of the above, it is desirable to provide a wafer, exposure mask, method for detecting an alignment mark, and/or method of exposure, which is capable of improving accuracy of alignment including correction of a gap between a wafer and an exposure mask.

According to an aspect of the present invention, there is provided a wafer having alignment marks on its exposure surface, which have edges for making inspection light for alignment scatter in a proximity exposure. Specifically, the wafer is characterized with a configuration of the alignment marks. That is, the alignment mark is configured to have a plurality of dot pattern groups. Each of the dot pattern groups is configured to have a plurality of dot patterns arrayed in a predetermined direction. Further, the plurality of dot pattern groups are arrayed in the predetermined direction with an interval between the dot pattern groups, and the interval is wider than an interval between the dot patterns.

In the wafer having such a configuration, the edges making the inspection light scatter during the alignment are provided by the dot patterns that form the alignment mark. Further, on the exposure surface, each of the dot pattern groups is formed from the dot patterns arrayed in the predetermined direction. Further, the dot pattern groups are arrayed in the aforementioned predetermined direction with the interval in between, which is wider than the interval for the dot patterns. Accordingly, if the inspection light H is radiated onto the exposure surface from an oblique direction so as that its plane of incidence is parallel to the arrangement direction of the dot patterns. With these edges arranged in high density, portions of higher signal strength at which more inspection light is scattered are generated periodically in the arrangement direction of the dot patterns. Accordingly, in the portions of the higher signal strength, strength for detecting the alignment mark of the wafer may be enhanced to an adequate value. Furthermore, the signal strength changes periodically in the vicinity of the focus position of the inspection light. In other words, changes of the signal strength in the vicinity of the focus positions may be enhanced and the accuracy of detecting the focus position may be improved.

Further, according to embodiments of the present invention, there are provides an exposure mask, method for detecting an alignment mark, and/or method for exposure, which have alignment marks.

### BRIEF DESCRIPTION OF THE DRAWINGS

These and other objects, features and advantages of the present invention will become more apparent in light of the following detailed description of a best mode embodiment thereof, as illustrated in the accompanying drawings:
Fig.1 is a diagram showing a configuration of an alignment mark provided in a wafer according to an embodiment of the present invention;
Fig.2 is a diagram showing another example of a configuration of an alignment mark provided in a wafer according to an embodiment of the present invention;
Fig.3 is a diagram explaining one of the related art;
Fig.4 is a diagram describing an inspection optic system in a SLA method; and
Fig.5 is a graph describing a signal processing in a SLA method.

### DESCRIPTION OF THE EMBODIMENTS

Below, embodiments of the present invention will be described in detail with reference to the drawings.

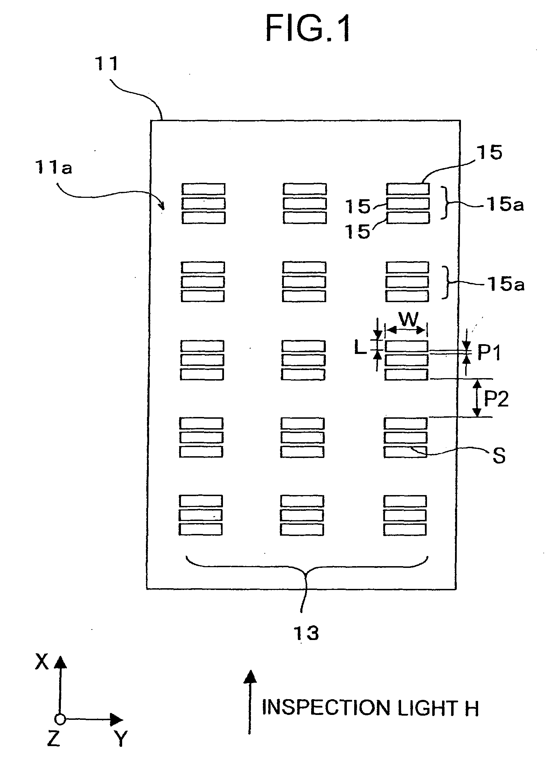

FIG. 1 is a close-up view showing an alignment mark in a wafer according to an embodiment of the present invention. A wafer 11 shown in Fig. 1 is to be aligned by use of a SLA method in proximity exposure as described in a section of "Description of Related Art". A exposure surface 11a is provided with an alignment mark (below, referred to as a wafer mark) 13 having the following configuration.

The wafer mark 13 is formed from dot pattern groups 15a arrayed in a plurality of rows in a predetermined direction. The dot pattern group 15a is formed from a plurality of dot patterns 15 arrayed in the same predetermined direction.

Each of the dot patterns 15 is a raised or grooved rectangular pattern having a predetermined length L in the arrangement direction of the dot pattern 15 (direction X in the present embodiment) and a predetermined width W in a direction perpendicular to the direction X. Each of the dot pattern group 15a formed from the dot patterns 15 described above. In the dot pattern group, a plurality of the dot patterns 15 are arrayed in the arrangement direction X with a predetermined arrangement interval P1. For example, in the present embodiment, the dot pattern group 15a is configured such that three dot patterns 15 of length L = 0.5 µm by width W = 2.0 µm are arrayed in the arrangement direction X (a direction of length L) at the arrangement interval P1 = 0.2 µm.

Further, the wafer mark 13 is formed from a plurality of the dot pattern groups 15a that are arrayed along the arrangement direction X of the dot pattern 15 at an arrangement interval P2. The arrangement interval P2 is wider than both the arrangement interval P1 of the dot pattern 15 and the length L of the dot pattern 15. Here, for example, the wafer mark 13 is configured at the arrangement interval P2 = 2 µm. Further, a row of the dot pattern groups 15a arrayed in the direction X at the arrangement interval P2 is formed from three rows in the direction Y. For example, an interval in the direction X of the dot pattern groups 15a is approximately 0.2 µm.

Alternatively, the wafer mark 13 described above may be of a configuration in which a slit S is provided in each of the dot patterns of a wafer mark in the related art.

An arrangement state of the wafer mark 13 on the exposure surface 11a described above has a similar configuration as that of a wafer mark in the related art. For example, two wafer marks 7' in the configuration described with reference to Fig. 3 are replaced with the wafer mark 13 having the configuration described in any one of the respective embodiments. Further, these wafer marks 13 are, for example, arranged at a plurality of positions on the exposure surface 11a of the wafer 11 in respective directions (direction X, direction Y).

For the proximity exposure to the wafer 11 having the wafer mark 13 described above, the alignment in accordance with the SLA method is executed as in the related art. Namely, an exposure mask, which has the same mask marks as in the related art, is disposed in the predetermined state in proximity onto the exposure surface 11a of the wafer 11 that is disposed on an exposure apparatus. Scattered lights of an inspection light H from the mask mark and wafer mark 13 are detected as an image signal by inspection optic systems disposed in respective portions around the exposure mask. In the inspection, edges making the inspection light H scatter are provided by the dot pattern 15 forming the wafer mark 13.

In the wafer mark 13 having the configure described above, the dot pattern groups 15a, each of which is formed from the dot patterns 15 arrayed in the predetermined direction X, are arrayed in the predetermined direction X at the arrangement interval P2, that is wider than the arrangement interval P1 for the dot patterns 15. Accordingly, if the inspection light H is radiated onto the exposure surface 11a in a downward oblique direction so as that its plane of incidence is parallel to the arrangement direction X of the dot patterns. With these edges arranged in high density, portions of higher signal strength at which more inspection light is scattered are generated periodically in the arrangement direction X of the dot patterns.

Accordingly, in the portions of the higher signal strength, strength for detecting the alignment mark of the wafer may be enhanced to an adequate value. Accordingly, as shown in Fig. 5B, the signal strength 52 in the direction perpendicular to the arrangement direction of the dot pattern 5 may be increased up to approximately the same level by the use of the wafer mark and the mask mark in the exposure mask side, thereby improving the accuracy of detecting misalignment in the X-Y component, θ component and magnification component between the wafer and the exposure mask.

Further, the signal strength in the arrangement direction X changes periodically in the vicinity of the focus position of the wafer mark 13. As illustrated in Fig. 5B, a derivative value 52 of the signal strength in the arrangement direction of the dot pattern 5 may greatly change within a smaller range in the vicinity of a focus position FP1 of the wafer mark, thereby improving the accuracy of detecting the focus position FP1. Accordingly, the accuracy of detecting the gap G between the wafer and the exposure mask may be improved.

As a result of the above, it is possible to improve the accuracy of alignment including controlling of a gap between a wafer and an exposure mask in an alignment in a SLA method.

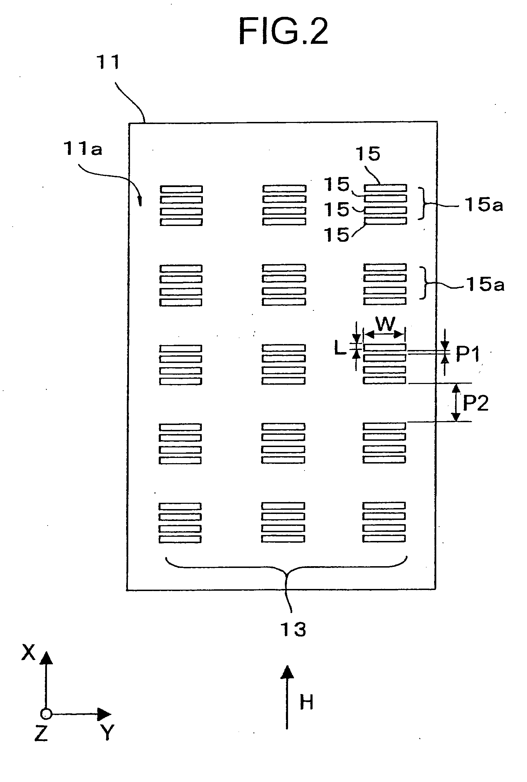

In the embodiment described above, it is described about a case that single dot pattern group 15a is formed from three dot patterns 15. However, the present invention is not limited only to the embodiment described above. Alternatively, as illustrated in Fig. 2, single dot pattern group 15 may be formed from four and more dot pattern 15, or may be formed from two dot patterns 15. In this case, the signal strength may be increased by making the length of the dot pattern 15 shorter and making the arrangement interval P1 narrower.

Further, the period of the above-mentioned signal strength changes in accordance with the length of the dot pattern groups 15a in the arrangement direction X and the arrangement interval P2. Accordingly, the accuracy of detecting the focus position may be further improved by appropriately setting the arrangement interval P2 in accordance with the size of gap between the exposure mask and the wafer in such a way that the differential waveform becomes sharper (in other words, resolution for separating a spot is ensured).

Alternatively, the wafer mark 13 having the above-mentioned configuration may be disposed onto the exposure mask as it is as an alignment mark (mask mark) for the exposure mask. For example, the mask mark 7 having the configuration described above with reference to Fig. 3 may be replaced with the wafer mark (alignment mark) 13 and used as a mask mark. Accordingly, by employing such a mask mark on the exposure mask, the signal strength on the exposure mask during the alignment in a SLA method may be enhanced. Accordingly, if the exposure surface of the wafer is formed from a material with high reflectivity, the signal strength of the mask mark may be improved to the same level or substantially the same level as that of the wafer mark. Further, since it is possible to improve the accuracy of detecting the focus position of the mask mark, the accuracy of detecting the gap G between the wafer and the exposure mask may be further improved by the use of such a mask mark in conjunction with a wafer mark.

As described above, according to the wafer, exposure mask, method for detecting alignment mark and method for exposure of the embodiments of the present invention, in alignment in accordance with a SLA method, it is possible to enhance the signal strength for detecting deviations in a X-Y component, θ component and magnification component, and to improve the accuracy of detecting a focus position for detecting the gap between an exposure mask and a wafer. Accordingly, it is possible to improve the accuracy of alignment including controlling of the gap between an exposure mask and a wafer.

It should be understood by those skilled in the art that various modifications, combinations, sub-combinations and alterations may occur depending on design requirements and other factors insofar as they are within the scope of the appended claims or the equivalents thereof.

## Claims

1. A wafer configured to have alignment marks on an exposure surface, the alignment marks having edges for scattering inspection light for alignment during an exposure:
wherein the alignment mark is configured to have a plurality of dot pattern groups, each of the dot pattern groups being configured to have a plurality of dot patterns arrayed in a predetermined direction, and
the plurality of dot pattern groups are arrayed in the predetermined direction with an interval between the dot pattern groups, the interval being wider than an interval between the dot patterns.

2. The wafer according to claim 1, wherein the dot pattern is formed by performing a proximity exposure.

3. The wafer according to claim 1, wherein the dot pattern is a raised or grooved rectangular pattern.

4. The wafer according to claim 1, wherein the dot pattern formed in a plurality of rows in the predetermined direction.

5. The wafer according to claim 1, wherein the alignment marks are disposed at a plurality of portions in respective directions.

6. An exposure mask configured to have alignment marks on a surface, the alignment marks having edges for scattering inspection light for alignment:
wherein the alignment mark is configured to have a plurality of dot pattern groups, each of the dot pattern groups being configured to have a plurality of dot patterns arrayed in a predetermined direction, and
the plurality of dot pattern groups are arrayed in the predetermined direction with an interval between the dot pattern groups, the interval being wider than an interval between the dot patterns.

7. The exposure mask according to claim 6, wherein the dot pattern formed in a plurality of rows in the predetermined direction.

8. The exposure mask according to claim 6, wherein the alignment marks are disposed at a plurality of portions in respective directions.

9. A method for detecting an alignment mark, comprising the steps of:
radiating inspection light for alignment to a surface of wafer in such a way that the inspection light is incident on an alignment mark in a surface of the wafer and scattered therein before exposure with an exposure mask,
wherein the exposure mask has alignment marks, the alignment marks being configured to have a plurality of dot pattern groups, each of the dot pattern groups being configured to have a plurality of dot patterns arrayed in a predetermined direction, and the plurality of dot pattern groups being arrayed in the predetermined direction with an interval between the dot pattern groups, the interval being wider than an interval between the dot patterns,
the alignment mark of the wafer has a same pattern as that of the dot pattern of the exposure mask.

10. The method for detecting an alignment mark according to claim 9,
wherein the inspection light for alignment is incident on the exposure mask and the wafer in an oblique direction.

11. The method for detecting an alignment mark according to claim 9,
wherein the inspection light is radiated onto the exposure surface from an oblique direction in such a way that a plane of incidence of the inspection light is parallel to the arrangement direction of the dot patterns.

12. The method for detecting an alignment mark according to claim 9, wherein the exposure is a proximity exposure.

13. The method for detecting an alignment mark according to claim 9,
wherein the detecting of scattered inspection light is performed by differentiation-processing of a signal strength along the arrangement direction of dot patterns.

14. The method for detecting an alignment mark according to claim 9,
wherein peaks of higher signal strength with stronger scattering of the inspection light are arranged periodically in the direction of arrayed dot pattern.

15. An exposure method comprising the steps of:
performing an alignment by causing scattering of inspection light for alignment at an alignment mark on a surface of an exposure mask, and
performing an exposure of a wafer via the exposure mask,
wherein the exposure mask is configured to have alignment marks, the alignment marks being configured to have a plurality of dot pattern groups, each of the dot pattern groups being configured to have a plurality of dot patterns arrayed in a predetermined direction, and the plurality of dot pattern groups being arrayed in the predetermined direction with an interval between the dot pattern groups, the interval being wider than an interval between the dot patterns.

16. The exposure method according to claim 15,
wherein the inspection light for alignment is incident on the exposure mask and the wafer in an oblique direction.

17. The exposure method according to claim 15,
wherein the inspection light is radiated onto the exposure surface from an oblique direction in such a way that a plane of incidence of the inspection light is parallel to the arrangement direction of the dot patterns.

18. The exposure method according to claim 15, wherein the exposure is a proximity exposure.

19. The exposure method according to claim 15,
wherein the detecting of scattered inspection light is performed by differentiation-processing of a signal strength along the arrangement direction of dot patterns.

20. The exposure method according to claim 15,
wherein peaks of higher signal strength with stronger scattering of the inspection light are arranged periodically in the direction of arrayed dot pattern.
